# EUROPEAN PATENT SPECIFICATION

(11) **EP 3 886 206 B1**
(45) Date of publication and mention of the grant of the patent: **10.05.2023**
(21) Application number: 20165657.6
(22) Date of filing: 25.03.2020
(51) Int. Cl.: H01M 10/48, H01M 50/502, H01R 11/22

(54) **MEASURING ASSEMBLY FOR MEASURING A TEMPERATURE AND A VOLTAGE**
MESSANORDNUNG ZUR MESSUNG EINER TEMPERATUR UND EINER SPANNUNG
ENSEMBLE POUR MESURER UNE TEMPÉRATURE ET UNE TENSION

(43) Date of publication of application: 29.09.2021
(73) Proprietor: Samsung SDI Co., Ltd., Gyeonggi-do 17084 (KR)
(72) Inventor: Haring, Fritz, 8600 Bruck / Mur (AT); Köppel, Andreas, 8144 Haselsdorf-Tobelbad (AT)
(74) Representative: Gulde & Partner

(56) References cited:
- EP-A1- 2 842 797
- JP-A- 2016 018 741
- US-A1- 2015 372 354
- US-A1- 2018 342 717

## Description

### Field of the Invention

The present invention relates to a measuring assembly for measuring a temperature and a voltage. Further, a battery system with such a measuring assembly and an electrical vehicle with such battery system are disclosed.

### Technological Background

In recent years, vehicles have been developed using electric power as a source of motion. An electric vehicle is an automobile that is powered by an electric motor using energy stored in rechargeable batteries. An electric vehicle may be solely powered by batteries or may be a form of hybrid vehicle powered by for example a gasoline generator. Furthermore, the vehicle may include a combination of electric motor and conventional combustion engine. In general, an electric-vehicle battery (EVB) or traction battery is a battery used to power the propulsion of battery electric vehicles (BEVs). Electric-vehicle batteries differ from starting, lighting, and ignition batteries because they are designed to give power over sustained periods of time. A rechargeable or secondary battery differs from a primary battery in that it can be repeatedly charged and discharged, while the latter provides only an irreversible conversion of chemical to electrical energy. Low-capacity rechargeable batteries are used as power supply for small electronic devices, such as cellular phones, notebook computers and camcorders, while high-capacity rechargeable batteries are used as the power supply for hybrid vehicles and the like.

Rechargeable batteries may be used as a battery module formed of a plurality of unit battery cells coupled in series and/or in parallel so as to provide a high energy density, in particular for motor driving of a hybrid vehicle. A battery module may be formed by interconnecting the electrode terminals of the plurality of unit battery cells depending on a required amount of power and in order to realize a high-power rechargeable battery. The cells can be connected in series, parallel or in a mixture of both to deliver the desired voltage, capacity, or power density. Components of battery packs include the individual battery modules and the interconnects, which provide electrical conductivity between them.

For meeting the dynamic power demands of various electrical consumers connected to the battery system a static control of battery power output and charging is not sufficient. Thus, steady exchange of information between the battery system and the controllers of the electrical consumers is required. This information includes the battery systems actual state of charge, potential electrical performance, charging ability and internal resistance as well as actual or predicted power demands or surpluses of the consumers.

For meeting the dynamic power demands of various electrical consumers connected to the battery system a static control of battery power output and charging is not sufficient. Thus, steady exchange of information between the battery system and the controllers of the electrical consumers is required. This information includes the battery systems actual state of charge (SoC), potential electrical performance, charging ability and internal resistance as well as actual or predicted power demands or surpluses of the consumers.

Battery systems usually comprise a battery control unit for processing the aforementioned information. The battery control unit may comprise controllers of the various electrical consumers and contain suitable internal communication busses, e.g. a SPI or CAN interface. The battery control unit may further communicate with battery submodules, for example with cell supervision circuits or cell connection and sensing units. Thus, the battery control unit may be provided for managing the battery stack, such as by protecting the battery from operating outside its safe operating area, monitoring its state, calculating secondary data, reporting that data, controlling its environment, authenticating it and/or balancing it.

Busbars are electrical conductors which are adapted to carry an electrical current and distribute or transport electrical power. Often, as an example, busbars are used to electrically connect a positive and negative electrode terminal of battery cells, for example of neighboring battery cells or end terminals of a battery cell stack. The electrical quantities like the voltage and the temperature of the busbar are therefore of particular relevance and need to be carefully monitored. Therefore, these two quantities are regularly monitored to allow an instant reaction when it is detected that operating conditions of a battery system are not anymore met.

According to the state of the art, for detecting the temperature and the voltage of such a busbar a temperature sensor and a voltage sensor are separately provided and each of them is separately connected to the busbar. Thereby, each sensor requires a separate fixation. Usually, for each sensor insert bolts and screws are used to connect the sensors to the busbar which are expansive and failures at the screw cases may occur. An example for such bolt and screw fixation is presented in US 2015/372354 A1, which discloses a connecting terminal with a voltage connector and a temperature sensor which are electrically connected to the busbar by a screw and the temperature sensor are thermally coupled to the busbar.

It is thus an object of the present invention to overcome or reduce at least some of the drawbacks of the prior art and to provide a measuring assembly capable of combining the sensing of voltage and temperature and has an improved connection or contact to the busbar. Further objects of the invention become clear in the context of the following description.

### Summary of Invention

Embodiments of the present disclosure seek to solve at least one of the problems existing in the prior art to at least some extent. In particular, a measuring assembly for measuring the temperature and the voltage. The measuring assembly comprises a contact element comprising a temperature sensing means and an electrically conductive portion. The measuring assembly further comprises a voltage measurement conductor which is electrically connected to the conductive portion of the contact element. The measuring assembly further comprises an electrically conductive fixation element being a fixation clip which is electrically connected to the conductive portion of the contact element, wherein the fixation element is adapted such that it extends through a fixation hole of a busbar and connects to the busbar by an elastic force provided by the fixation element in a fixed state. Further, the fixation element being the fixation clip is adapted such that, in the fixed state, it presses the contact element to a measuring surface of the busbar by an elastic force provided by the fixation element in the fixed state.

Busbars generally refer to electrical conductors which are adapted to carry an electrical current to distribute or transport electrical power. As an example, busbars are used to electrically connect a positive and negative electrode terminal of battery cells, for example of neighboring battery cells or end terminals of a battery stack. A fixed state in other words may be referred to as an engaged state. That is a state in which the fixation element engages with the busbar such that induced elastic forces connect or press the fixation element to the busbar. An elastic force refers in other words to a force that results from tension or energy stored in the fixation element due to elastic deformation when fixed to the busbar. Therefore, the elastic force implies further that the fixation element is suitably elastically deformable and non-rigid. In the fixed state, the elastic force may then lead to the pressing of the contact element towards the busbar. The fixation element is a fixation clip. An electrical conductor may be a conductive wire.

A technical advantage is that the fixation element provides, in the fixed state, an elastic force such that the contact element is pressed against the busbar. Thereby, a stable contact, that is under tension, to the busbar is generated such that an improved heat transition and heat coupling from the busbar to the temperature sensing means is provided due to the pressed contact mediated by the elastic force of the fixation element in the fixed state. In consequence, the temperature measurement may be systematically improved and may be as such more accurate and closer to the real temperature at the busbar thereby reducing and/or eliminating systematic measurement errors. Even further, tolerances in the manufacturing process can be compensated by the provided elastic force in the fixed state. Also, only one connection via the contact element the measurement of temperature and voltage can be performed in a combined manner. No duplicative connections for the two sensing paths have to be provided. Further, costs can be reduced since no insert bolts are necessary. Also, the risk of failure at the screw case can be reduced.

Preferably, the contact element may comprise a contact side which, in the fixed state, contacts the busbar by forming a planar contact. Thereby, an improved heat transition is provided. A planar contact may be referred to as an areal contact zone between the contact side and the busbar or, more precise, the measuring surface of the busbar.

In a preferred embodiment, the fixation element may comprise a shaft portion which extends through the fixation hole in the fixed state and a bent portion which is connected to the shaft portion and which, in the fixed state, is bent from a shaft direction of the shaft portion towards the measuring surface of the busbar, wherein the contact element is connected to an end of the bent portion. The connection and landing of the contact element to the busbar is improved due the flat transition from bent portion to contact element.

Preferably, the end of the bent portion may contact the busbar in the fixed state and/or is oriented parallel to the measuring surface. Thereby, the connection of the contact element to the busbar is further improved.

In a preferred embodiment, an inner space may be formed between the bent portion and the busbar in the fixed state. Thereby, the induced elastic force acting on the contact element generated by the fixed fixation element may be increased.

Preferably, the fixation element may comprise a tip portion connected to the shaft portion comprising a width being greater than a width of the fixation hole in the fixed state such that the busbar is clamped between the contact element and the tip portion in the fixed state.

Thereby, a stable fixation of the contact element and, in consequence, the temperature sensor to the busbar is provided.

In a preferred embodiment, the tip portion may comprise a widening portion which widens with respect to the shaft portion and may comprise a narrowing portion which narrows towards a tip of the tip portion from the widening portion. By this geometry, the fixation element can be forced through the fixation hole to implement the fixed state by a force that overcomes the elastic deformation force. Also, the fixation can, in reverse, be releasably disengaged by a force that overcomes the elastic deformation force.

Preferably, the contact element may comprise an insulator adapted to fix the temperature sensing means in the contact element such that the temperature sensing means is electrically insulated from the voltage measurement conductor and/or the conductive portion. Thereby, the temperature sensor is protected from electricity in the busbar. Damage or faulty behavior of the temperature sensing means may be prevented by the insulation.

In a preferred embodiment, the insulator may be an epoxy resin. An epoxy resin is a suitable insulator for the voltages of typical busbar applications in battery systems for electric vehicles and may be suitable for large range of voltages, i.e. 12 V, 48V, 500 V, 1000 V but the invention is not restricted to these voltages.

Preferably, the fixation element may be formed of a metal sheet part. This allows a fast manufacture of the particular form of the fixation element and the required shape to generate the elastic forces required in the fixed state.

In a preferred embodiment, the voltage measurement conductor may be connected to the contact element by a weld. Preferably, an ultrasonic weld is provided. Thereby, a stable electric connection for high voltages is advantageously provided.

Preferably, the conductive portion of the contact element and the fixation element may be integrally formed. Thereby, mechanical strength and conductivity is improved of the measuring assembly due to the avoidance of interface resistances.

Preferably, a contact direction of the contact side of the contact element may be tilted with respect to the shaft direction in the unfixed state, such that an acute angle α>0° is formed between the shaft direction and the contact direction of the contact side of the contact element in the unfixed state. This may ensure that the planar contact is kept also under the effective elastic force in the fixed state, in particular on the side of the contact element facing away from the fixation element.

In another aspect of the invention, a battery pack comprising a measuring assembly according to one of the embodiments as described above and in the following is provided.

In another aspect of the invention, a battery system comprising a measuring assembly according to one of the embodiments as described above and in the following is provided. Safety for the battery pack and the battery system can be improved because at positions like the main relays the temperature measurement combined with the voltage measurement can be implemented and realized.

Further, an electrical vehicle including a battery system according to an embodiment as described above or as described in the following.

Further aspects of the present invention could be learned from the dependent claims or the following description.

### Brief Description of the Drawings

Features will become apparent to those of ordinary skill in the art by describing in detail exemplary embodiments with reference to the attached drawings in which:
Fig. 1 illustrates a perspective view of a measuring assembly according to an embodiment of the invention with a busbar;
Fig. 2 illustrates a perspective view illustrating the connection of a contact element according to an embodiment of the invention;
Fig. 3 illustrates a perspective view illustrating a contact element with a temperature sensing means according to an embodiment of the invention;
Fig. 4 illustrates a perspective view of a measuring assembly according to an embodiment of the invention;
Fig. 5 illustrates a perspective view of a measuring assembly according to an embodiment of the invention with the busbar in side view perspective; and
Fig. 6 illustrates a perspective view of a measuring assembly according to another embodiment of the invention with the busbar in side view perspective.

### Detailed Description of the Invention

Reference will now be made in detail to embodiments, examples of which are illustrated in the accompanying drawings. Effects and features of the exemplary embodiments, and implementation methods thereof will be described with reference to the accompanying drawings. In the drawings, like reference numerals denote like elements, and redundant descriptions are omitted. As used herein, the term "and/or" includes any and all combinations of one or more of the associated listed items. Further, the use of "may" when describing embodiments of the present invention refers to "one or more embodiments of the present invention."

In the following description of embodiments of the present invention, the terms of a singular form may include plural forms unless the context clearly indicates otherwise.

It will be further understood that the terms "include," "comprise," "including," or "comprising" specify a property, a region, a fixed number, a step, a process, an element, a component, and a combination thereof but do not exclude other properties, regions, fixed numbers, steps, processes, elements, components, and combinations thereof.

In the drawings, the sizes of elements may be exaggerated for clarity. For example, in the drawings, the size or thickness of each element may be arbitrarily shown for illustrative purposes, and thus the embodiments of the present invention should not be construed as being limited thereto.

The present invention, however, may be embodied in various different forms, and should not be construed as being limited to only the illustrated embodiments herein. Rather, these embodiments are provided as examples so that this disclosure will be thorough and complete, and will fully convey the aspects and features of the present invention to those skilled in the art. Accordingly, processes, elements, and techniques that are not necessary to those having ordinary skill in the art for a complete understanding of the aspects and features of the present invention may not be described. Unless otherwise noted, like reference numerals denote like elements throughout the attached drawings and the written description, and thus, descriptions thereof will not be repeated. In the drawings, the relative sizes of elements, layers, and regions may be exaggerated for clarity.

The terminology used herein is for the purpose of describing particular embodiments only and is not intended to be limiting of the present invention.

As used herein, the term "substantially", "about" and similar terms are used as terms of approximation and not as terms of degree, and are intended to account for the inherent deviations in measured or calculated values that would be recognized by those of ordinary skill in the art. Further, if the term "substantially" is used in combination with a feature that could be expressed using a numeric value, the term "substantially" denotes a range of +/- 5% of the value centered on the value. Further, the use of "may" when describing embodiments of the present invention refers to "one or more embodiments of the present invention." Herein, the terms "upper" and "lower" are defined according to the z-axis.

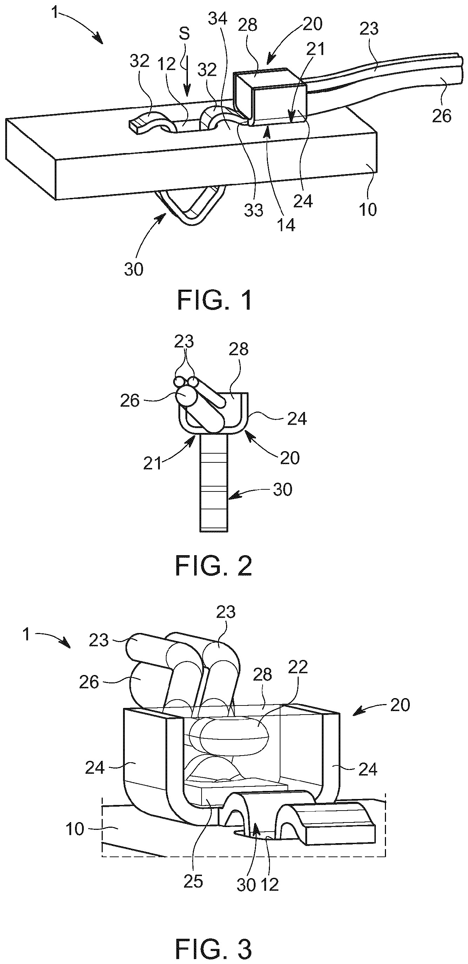

Figure 1 shows a measuring assembly 1 for measuring a temperature and a voltage according to an embodiment of the invention with a busbar 10. In the following, also the Figs. 2 to 4 will be described simultaneously. Figs. 2 to 4 show embodiments of the measuring assembly 1 viewed from different angles or, as in Fig. 2 and Fig. 3, without the busbar 10 such that various features of embodiments of a measuring assembly 1 can be disclosed in more detail.

The busbar 10 may be an electrical conductor to carry an electric current. The busbar 10 may be for example used to electrically connect a positive and negative electrode terminal of battery cells, for example of neighboring or end terminals of a battery system and/or a battery pack.

The busbar 10 comprises a fixation hole 12. Such a fixation hole 12 may be manufactured by cutting a hole into the busbar 10 which is a fast and cheap process. In the present example embodiment, the fixation hole 12 may be a slot or an oblong hole, see Fig. 1, but the invention is not restricted thereto. The fixation hole 12 may also be round or rectangular, for example.

The measuring assembly 1 further comprises a contact element 20. The contact element 20 comprises a temperature sensing means 22, see for example Fig. 3. The temperature sensing means 22 may be a suitable temperature sensor to measure the temperature at the busbar 10. For example, the temperature sensor may be a semiconductor bandgap temperature sensor or for example a thermocouple, but the invention is not restricted thereto and any suitable temperature sensor may be utilized in the present invention.

Further, the contact element 20 comprises an electrically conductive portion 24. In the present example embodiment, see for example Figs. 1 to 4, the conductive portion 24 may be formed at least on a bottom side of the contact element 20 facing the busbar 10 in the fixed state. The conductive portion 24 may additionally be formed on at least one of opposite side surfaces connected to the bottom surface. The conductive portion 24 may also have a "u"-formed shape, see for example Fig. 2. In other embodiments, the conductive portion 24 may only be formed on the bottom side facing the busbar 10 in the fixed state.

Further, the measuring assembly 1 comprises a voltage measurement conductor 26. The voltage measurement conductor 26 is electrically connected to the conductive portion 24 of the contact element 20. For example, a connector 25 may be provided to which the voltage measurement conductor 26 is electrically connected to. The connector 25, for example plate shape, may for example be connected to the conductive portion 24 of the contact element 20, but the invention is not restricted thereto and the connection of the voltage measurement conductor 26 may be performed directly to the conductive portion 24. For example, as can be seen in Fig. 1 and 2, the voltage measurement conductor 26 may preferably be connected to the conductive portion 24 on a side facing away from a fixation element 30, see the description below, but the invention is not restricted thereto. The voltage measurement conductor 26 may preferably be connected to the contact element 20 by a weld, particularly by an ultrasonic weld to provide a strong connection. A linearly formed plug is formed by the geometrical assembly which can be simply and intuitively be attached to the fixation hole 12 via the fixation element 30, which will be explained in more detail below. In a preferred embodiment, the voltage measurement conductor 26 may be a high voltage wire. Also, temperature measurement conductors 23 may be provided to transmit a low voltage differential signal indicative of a measured temperature of the busbar 10 measured by the temperature sensing means 22. The temperature measurement conductors 23 may be connected to the contact element 20 and to the temperature sensing means 22 on the same side of the contact element as the voltage measurement conductor 26.

Further, the measuring assembly 1 comprises an electrically conductive fixation element 30 being a fixation clip.

In particular, the fixation element 30 may be suitably elastically deformable and, in particular, compressible for fixation. The fixation element 30 is electrically connected to the conductive portion 24 of the contact element 20.

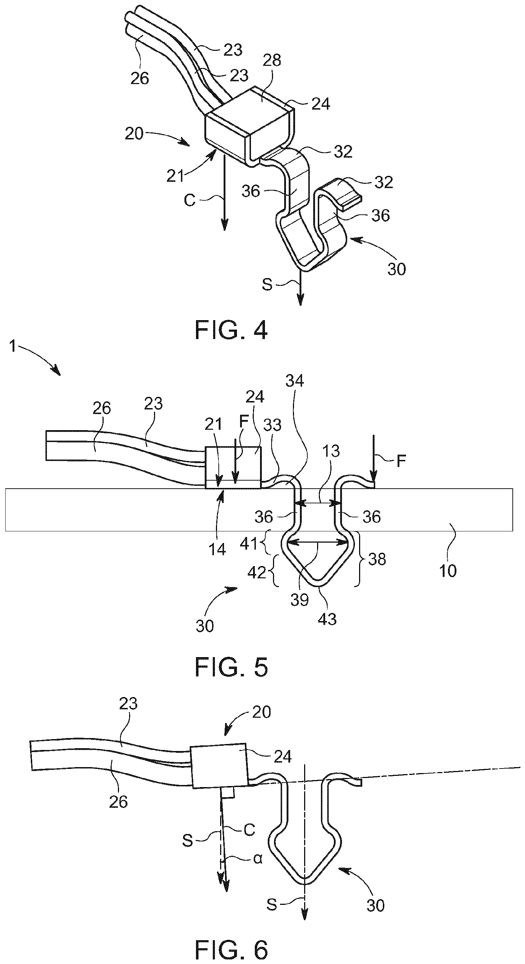

The fixation element 30 is formed such that it passes through the fixation hole 12 in the fixed state as shown for example in Fig. 1 and Fig. 5. The fixation element 30 is further adapted to connect to the busbar 10 by an elastic force F provided by the fixation element 30 in a fixed state. The elastic force may be a response to elastic tension stored in the fixation element 30 provided by the fixation element 30 when engaging with the busbar 10, see for an illustration Fig. 5.

Further, the fixation element 30 is adapted such that, in the fixed state, it presses the contact element 20 to a measuring surface 14 of the busbar 10. The pressing is generated by an elastic force F provided by the fixation element 30. In other words, by engaging of the fixation element 30 with the busbar 10, an elastic tension is generated and deformation energy stored in the fixation element 30 resulting in the provision of an elastic force F acting on the contact element 20 to press the contact element 20 towards the measuring surface 14 of the busbar 10. Such a resulting force F is schematically shown in Fig. 5 for illustration purposes, only. By the induced elastic force F due to the connected fixation element 30, the contact element 20 is in a strong coupling contact with the busbar 10. The temperature measurement is improved, since the heat transition from the busbar 10 towards the contact element 20 and thereby towards the temperature sensing means 22 facilitated. In consequence, the temperature measurement may be systematically improved and may be as such more accurate and closer to the real temperature at the busbar 10 thereby reducing and/or eliminating systematic measurement errors. Even further, tolerances in the manufacturing process can be compensated by the provided elastic force in the fixed state.

The contact element 20 may comprise a contact side 21 which, in the fixed state, contacts the busbar 10 under the formation of a planar contact. Due to the planar contact the heat transition and transport from the busbar 10 to the temperature sensing means 22 is further improved to enhance the precision of the temperature measurement of the busbar 10. In the unfixed state, e.g. visible in Fig. 4, a contact direction C of the contact side 21 of the contact element may be oriented parallel to the shaft direction S.

Since the fixation element 30 is electrically conductive and contacts the busbar 10, the conductive portion 24 of the contact element 20 is on the same electrical potential. Thus, the voltage measurement conductor 26 is directly sensing the potential/voltage of the busbar 10. It is an advantage of the present invention that via only one connection via the contact element 20 the measurement of temperature and voltage can be performed in a combined manner. No duplicative connections for the two sensing paths have to be provided.

In a preferred embodiment, the conductive portion 24 of the contact element 20 and the fixation element 30 may be integrally formed to mechanically strengthen the assembly and reduce interface conductive resistance. Then, a one-pieced sensor plug to measure temperature and voltage in a combined way is provided.

In the following, preferred embodiments of the fixation element 30 are described in more detail. Preferably, the fixation element 30 may be formed of a metal sheet part. Then the fixation element 30 may be manufactured by bending a stripe of conductive, for example, a metal sheet. As can be seen for example in Fig. 4, the fixation element 30 may comprise a shaft portion 36. The shaft portion 36 may be a straight part, which is oriented in a shaft direction S. The shaft direction S may be oriented parallel to the extension of the fixation hole 12 through the busbar 10 in the fixed state. The shaft portion 36 may extend through the fixation hole 12 in the fixed state. The shaft portion 36 may provide a friction contact with inner walls of the fixation hole 12 in the fixed state.

The fixation element 30 may comprise a bent portion 32. The bent portion 32 may be connected to the shaft portion 36 and may bend from the shaft direction S of the shaft portion 36 towards the measuring surface 14 of the busbar 10.

The contact element 20, in particular the conductive portion of the contact element 20, may be connected to the bent portion 32 of the fixation element 30. Preferably, the conductive portion 24 of the contact element 20 may be connected to a flat end 33 of the bent portion 32, as can be seen for example in Figs. 1 or Fig. 5. Thus, no distortion of the contact element 24 and better contact may be provided. In other embodiments, a flat portion, here not shown, may be interconnected between the flat end 33 and the contact element 20.

As can be seen for example in Fig. 1, the flat end 33 of the bent portion 32 may be in contact with the busbar 10 in the fixed state. The flat end 33 may for example be oriented parallel to the measuring surface 14 of the busbar 10 in the fixed state. Thereby, the connection and landing of the contact element 20 to the measuring surface 14 of the busbar 10 may be improved.

An inner space 34 may be formed between the bent portion 32 and the busbar 10 in the fixed state, as can be seen in the various embodiments. Due to the inner space 34 the bent portion 32 does not directly follow the edge of the fixation hole 12. In other words, the curvature of the bent portion 32 is less than the curvature of the edge at the fixation hole 12. The bent portion 32 may support to provide an effective normal elastic force F to press the contact element 20 to the busbar 10.

The fixation element 30 may preferably comprise a tip portion 38 which is connected to the shaft portion 36. The tip portion 38 may comprise a maximum width 39 being greater than a width 13 of the fixation hole 12 and the shaft portion 36. Thereby, the busbar 10 may be clamped between the contact element 20 and the tip portion 38 in the fixed state. Thus, a strong coupling of the contact element 20 to the busbar 10 is provided by the fixation element 30 to improve the heat transition to the temperature sensing means 22.

The tip portion 38 may, more specifically, comprise a widening portion 41 which widens with respect to the shaft portion 36 and a narrowing portion 42 which narrows towards a tip 43 of the tip portion 38 from the widening portion 41 in the shaft direction S. The maximum width 39 may be located at the transition from the widening portion 41 and the narrowing portion 42. The geometry of the tip portion 38 may be referred to as an arrow-shaped contour. The advantage of the geometry is that the fixation element 30 can be readily pressed into the fixation hole 12 and, reversely, be pressed out of the fixation hole 12 by overcoming a force to compress the fixation element 30 such that it fits through the fixation hole 12.

The contact element 20 may comprise an insulator 28. The insulator 28 may be viewed for example in any of the Figs. 1 to 4. The insulator 28 may be adapted and positioned in the contact element 20 such that the temperature sensor means 22 is fixed in the contact element 20. The temperature sensing means 22 may be electrically insulated from the voltage measurement conductor 26 and/or the conductive portion 24. For example, the temperature sensing means 22 may be spaced from the voltage measurement conductor 26 and/or the conductive portion 24 and the insulator 28 may be located or filled between the voltage measurement conductor 26 and/or the conductive portion 24 and the temperature sensing means 22, see for example Fig. 3. Temperature measurement is thereby thus less effected by electric disturbance. Preferably, the insulator 28 may be an epoxy resin which is most suitable for voltages applicable for busbars 10 for battery modules and/or battery systems. Thereby, the insulation between temperature sensor and voltage measurement is ensured.

Fig. 6 shows a perspective view of a measuring assembly according to another embodiment of the invention without the busbar in side view perspective. The measuring assembly is hereby shown in the unfixed state. In this further embodiment, a contact direction C of the contact side 21 of the contact element 20, forming a right angle with the contact side 21 as indicated by the right angle symbol, is tilted with respect to the shaft direction S such that an acute angle α>0° between the shaft direction S and the contact direction C of the contact side 21 is formed in the unfixed state. The angle may be less than 25°, preferably less than 20°, more preferred less than 15°. This tilted angle α may improve that, in the fixed state, when elastic forces act on the contact element 20, the planar contact of the contact element 20 and the busbar 10 without a lifting due to the acting normal forces F can be retained.

### Reference signs

- 1: measuring assembly

- 10: busbar
- 12: fixation hole
- 13: width
- 14: measuring surface

- 20: contact element
- 21: contact side
- 22: temperature sensing means
- 23: temperature measurement conductor
- 24: conductive portion
- 25: connector
- 26: voltage measurement conductor
- 28: insulator

- 30: fixation element
- 32: bent portion
- 33: end
- 34: inner space
- 36: shaft portion
- 38: tip portion
- 39: tip width
- 41: widening portion
- 42: narrowing portion
- 43: tip
- S: shaft direction
- C: contact direction

## Claims

1. A measuring assembly (1) for measuring a temperature and a voltage, comprising:
- a contact element (20) comprising a temperature sensing means (22) and an electrically conductive portion (24);
- a voltage measurement conductor (26) which is electrically connected to the conductive portion (24) of the contact element (20);
**characterized in that**,
the assembly (1) further comprises an electrically conductive fixation element (30) being a fixation clip, which is electrically connected to the conductive portion (24) of the contact element (20), wherein the fixation element (30) is adapted such that it extends through a fixation hole (12) of a busbar (10) in a fixed state and connects to the busbar (10) by an elastic force provided by the fixation element (30) in the fixed state; and
wherein the fixation element (30) being the fixation clip is adapted such that, in the fixed state, it presses the contact element (20) to a measuring surface (14) of the busbar (10) by an elastic force provided by the fixation element (30) in the fixed state.

2. The measuring assembly (1) of claim 1, wherein the contact element (20) comprises a contact side (21) which, in the fixed state, contacts the busbar (10) by forming a planar contact.

3. The measuring assembly (1) of one of the claims 1 to 2, wherein the fixation element (30) comprises a shaft portion (36) which extends through the fixation hole (12) in the fixed state and a bent portion (32) which is connected to the shaft portion (36) and which, in the fixed state, is bent from a shaft direction (S) of the shaft portion (36) towards the measuring surface (14) of the busbar (10), wherein the contact element (20) is connected to an end (33) of the bent portion (32).

4. The measuring assembly (1) of claim 3, wherein the end (33) of the bent portion (32) contacts the busbar (10) in the fixed state and/or is oriented parallel to the measuring surface (14).

5. The measuring assembly (1) of claim 4, wherein an inner space (34) is formed between the bent portion (32) and the busbar (10) in the fixed state.

6. The measuring assembly (1) of one of the claims 3 to 5, wherein the fixation element (30) comprises a tip portion (38) connected to the shaft portion (36) comprising a width (39) being greater than a width (13) of the fixation hole (12) in the fixed state such that the busbar (10) is clamped between the contact element (20) and the tip portion (38) in the fixed state.

7. The measuring assembly (1) of claim 6, wherein the tip portion (38) comprises a widening portion (41) which widens with respect to the shaft portion (36) and a narrowing portion (42) which narrows towards a tip (43) of the tip portion (38) from the widening portion (41).

8. The measuring assembly (1) of one of the claims 1 to 7, wherein the contact element (20) comprises an insulator (28) adapted to fix the temperature sensing means (22) in the contact element (20) such that the temperature sensing means (22) is electrically insulated from the voltage measurement conductor (26) and/or the conductive portion (24).

9. The measuring assembly (1) of claim 8, wherein the insulator (28) is an epoxy resin.

10. The measuring assembly (1) of one of the claims 1 to 9, wherein the fixation element (30) is formed of a metal sheet part.

11. The measuring assembly (1) of one of the claims 1 to 10, wherein the voltage measurement conductor (26) is connected to the contact element (20) by a weld.

12. The measuring assembly (1) of one of the claims 1 to 11, wherein conductive portion (24) of the contact element (20) and the fixation element (30) are integrally formed.

13. The measuring assembly (1) of one of the claims 1 to 12, wherein a contact direction (C) of the contact side (21) of the contact element (20) is tilted with respect to the shaft direction (S) in the unfixed state, such that an acute angle α>0° is formed between the shaft direction (S) and the contact direction (C) in the unfixed state.

14. A battery system comprising a measuring assembly (1) according to one of the claims 1 to 13.

15. An electrical vehicle including a battery system of claim 14.

## Patentansprüche

1. Messanordnung (1) zum Messen einer Temperatur und einer Spannung, umfassend:
- ein Kontaktelement (20), das ein Temperaturerfassungsmittel (22) und einen elektrisch leitenden Abschnitt (24) aufweist;
- einen Spannungsmessleiter (26), der elektrisch mit dem leitenden Abschnitt (24) des Kontaktelements (20) verbunden ist;
**dadurch gekennzeichnet, dass**
die Anordnung (1) ferner ein elektrisch leitendes Befestigungselement (30) umfasst, das eine Befestigungsklammer ist, die elektrisch mit dem leitenden Abschnitt (24) des Kontaktelements (20) verbunden ist, wobei das Befestigungselement (30) so angepasst ist, dass es sich durch ein Befestigungsloch (12) einer Sammelschiene (10) in einem befestigten Zustand erstreckt und mit der Sammelschiene (10) durch eine elastische Kraft verbunden ist, die von dem Befestigungselement (30) in dem befestigten Zustand bereitgestellt wird; und
wobei das Befestigungselement (30), das die Befestigungsklammer ist, so angepasst ist, dass es im befestigten Zustand das Kontaktelement (20) durch eine elastische Kraft, die durch das Befestigungselement (30) im befestigten Zustand bereitgestellt wird, an eine Messfläche (14) der Sammelschiene (10) drückt.

2. Messanordnung (1) nach Anspruch 1, wobei das Kontaktelement (20) eine Kontaktseite (21) aufweist, die im befestigten Zustand die Sammelschiene (10) unter Ausbildung eines flächigen Kontaktes berührt.

3. Messanordnung (1) nach einem der Ansprüche 1 bis 2, wobei das Befestigungselement (30) einen Schaftabschnitt (36), der sich im befestigten Zustand durch das Befestigungsloch (12) erstreckt, und einen mit dem Schaftabschnitt (36) verbundenen gebogenen Abschnitt (32) aufweist, der im befestigten Zustand aus einer Schaftrichtung (S) des Schaftabschnitts (36) zur Messfläche (14) der Sammelschiene (10) hin gebogen ist, wobei das Kontaktelement (20) mit einem Ende (33) des gebogenen Abschnitts (32) verbunden ist.

4. Messanordnung (1) nach Anspruch 3, wobei das Ende (33) des gebogenen Abschnitts (32) die Sammelschiene (10) im befestigten Zustand berührt und/oder parallel zur Messfläche (14) ausgerichtet ist.

5. Messanordnung (1) nach Anspruch 4, wobei zwischen dem gebogenen Abschnitt (32) und der Sammelschiene (10) im befestigten Zustand ein Innenraum (34) ausgebildet ist.

6. Messanordnung (1) nach einem der Ansprüche 3 bis 5, wobei das Befestigungselement (30) einen Spitzenabschnitt (38) umfasst, der mit dem Schaftabschnitt (36) verbunden ist und eine Breite (39) aufweist, die größer ist als die Breite (13) des Befestigungslochs (12) im befestigten Zustand, so dass die Sammelschiene (10) im befestigten Zustand zwischen dem Kontaktelement (20) und dem Spitzenabschnitt (38) eingeklemmt ist.

7. Messanordnung (1) nach Anspruch 6, wobei der Spitzenabschnitt (38) einen Verbreiterungsabschnitt (41), der sich in Bezug auf den Schaftabschnitt (36) verbreitert, und einen Verengungsabschnitt (42) umfasst, der sich zu einer Spitze (43) des Spitzenabschnitts (38) hin von dem Verbreiterungsabschnitt (41) verengt.

8. Messanordnung (1) nach einem der Ansprüche 1 bis 7, wobei das Kontaktelement (20) einen Isolator (28) umfasst, der angepasst ist, um das Temperaturerfassungsmittel (22) in dem Kontaktelement (20) so zu befestigen, dass das Temperaturerfassungsmittel (22) von dem Spannungsmessleiter (26) und/oder dem leitenden Abschnitt (24) elektrisch isoliert ist.

9. Messanordnung (1) nach Anspruch 8, wobei der Isolator (28) ein Epoxidharz ist.

10. Messanordnung (1) nach einem der Ansprüche 1 bis 9, wobei das Befestigungselement (30) aus einem Metallblechteil ausgebildet ist.

11. Messanordnung (1) nach einem der Ansprüche 1 bis 10, wobei der Spannungsmessleiter (26) mit dem Kontaktelement (20) durch eine Schweißung verbunden ist.

12. Messanordnung (1) nach einem der Ansprüche 1 bis 11, wobei der leitende Abschnitt (24) des Kontaktelements (20) und das Befestigungselement (30) einstückig ausgebildet sind.

13. Messanordnung (1) nach einem der Ansprüche 1 bis 12, wobei eine Kontaktrichtung (C) der Kontaktseite (21) des Kontaktelements (20) im nicht befestigten Zustand bezüglich der Schaftrichtung (S) so gekippt ist, dass zwischen der Schaftrichtung (S) und der Kontaktrichtung (C) im unbefestigten Zustand ein spitzer Winkel α>0° ausgebildet ist.

14. Batteriesystem, umfassend eine Messanordnung (1) nach einem der Ansprüche 1 bis 13.

15. Elektrisches Fahrzeug, umfassend ein Batteriesystem nach Anspruch 14.

## Revendications

1. Ensemble de mesure (1) pour mesurer une température et une tension, comprenant :
un élément de contact (20) comprenant un moyen de détection de température (22) et une partie électriquement conductrice (24) ;
un conducteur de mesure de tension (26) qui est électriquement raccordé à la partie conductrice (24) de l'élément de contact (20) ;
**caractérisé en ce que** :
l'ensemble (1) comprend en outre un élément de fixation électriquement conducteur (30) qui est une attache de fixation, qui est électriquement raccordé à la partie conductrice (24) de l'élément de contact (20), dans lequel l'élément de fixation (30) est adapté de sorte qu'il s'étend à travers un trou de fixation (12) d'une barre omnibus (10) dans un état fixe et se raccorde à la barre omnibus (10) par une force élastique fournie par l'élément de fixation (30) dans un état fixe ; et
dans lequel l'élément de fixation (30) qui est l'attache de fixation, est adapté de sorte que, à l'état fixe, il comprime l'élément de contact (20) sur une surface de mesure (14) de la barre omnibus (10) par une force élastique fournie par l'élément de fixation (30) à l'état fixe.

2. Ensemble de mesure (1) selon la revendication 1, dans lequel l'élément de contact (20) comprend un côté de contact (21) qui, à l'état fixe, est en contact avec la barre omnibus (10) en formant un contact plan.

3. Ensemble de mesure (1) selon l'une des revendications 1 à 2, dans lequel l'élément de fixation (30) comprend une partie d'arbre (36) qui s'étend à travers le trou de fixation (12) à l'état fixe et une partie pliée (32) qui est raccordée à la partie d'arbre (36) et qui, à l'état fixe, est pliée d'une direction d'arbre (S) de la partie d'arbre (36) vers la surface de mesure (14) de la barre omnibus (10), dans lequel l'élément de contact (20) est raccordé à une extrémité (33) de la partie pliée (32).

4. Ensemble de mesure (1) selon la revendication 3, dans lequel l'extrémité (33) de la partie pliée (32) est en contact avec la barre omnibus (10) à l'état fixe et/ou est orientée parallèlement à la surface de mesure (14).

5. Ensemble de mesure (1) selon la revendication 4, dans lequel un espace interne (34) est formé entre la partie pliée (32) et la barre omnibus (10) à l'état fixe.

6. Ensemble de mesure (1) selon l'une des revendications 3 à 5, dans lequel l'élément de fixation (30) comprend une partie de pointe (38) raccordée à la partie d'arbre (36) comprenant une largeur (39) qui est supérieure à une largeur (13) du trou de fixation (12) à l'état fixe de sorte que la barre omnibus (10) est serrée entre l'élément de contact (20) et la partie de pointe (38) à l'état fixe.

7. Ensemble de mesure (1) selon la revendication 6, dans lequel la partie de pointe (38) comprend une partie d'élargissement (41) qui s'élargit par rapport à la partie d'arbre (36) et une partie de rétrécissement (42) qui se rétrécit vers une pointe (43) de la partie de pointe (38) à partir de la partie d'élargissement (41).

8. Ensemble de mesure (1) selon l'une des revendications 1 à 7, dans lequel l'élément de contact (20) comprend un isolateur (28) adapté pour fixer le moyen de détection de température (22) dans l'élément de contact (20) de sorte que le moyen de détection de température (22) est électriquement isolé du conducteur de mesure de tension (26) et/ou de la partie conductrice (24).

9. Ensemble de mesure (1) selon la revendication 8, dans lequel l'isolant (28) est une résine époxy.

10. Ensemble de mesure (1) selon l'une des revendications 1 à 9, dans lequel l'élément de fixation (30) est formé avec une partie de feuille métallique.

11. Ensemble de mesure (1) selon l'une des revendications 1 à 10, dans lequel le conducteur de mesure de tension (26) est raccordé à l'élément de contact (20) par une soudure.

12. Ensemble de mesure (1) selon l'une des revendications 1 à 11, dans lequel la partie conductrice (24) de l'élément de contact (20) et l'élément de fixation (30) sont formés de manière solidaire.

13. Ensemble de mesure (1) selon l'une des revendications 1 à 12, dans lequel une direction de contact (C) du côté de contact (21) de l'élément de contact (20) est inclinée par rapport à la direction d'arbre (S) à l'état non fixé, de sorte qu'un angle aigu α > 0° est formé entre la direction d'arbre (S) et la direction de contact (C) à l'état non fixé.

14. Système de batterie comprenant un ensemble de mesure (1) selon l'une des revendications 1 à 13.

15. Véhicule électrique comprenant un système de batterie selon la revendication 14.
